# EUROPEAN PATENT SPECIFICATION

(11) **EP 3 441 148 B1**
(45) Date of publication and mention of the grant of the patent: **08.04.2020**
(21) Application number: 18179482.7
(22) Date of filing: 25.06.2018
(51) Int. Cl.: B05B 16/20

(54) **PRINTING AND PAINTING DEVICE AND METHOD.**
DRUCK- UND BESCHICHTUNGSVORRICHTUNG SOWIE VERFAHREN
DISPOSITIF ET PROCESS DE PEINTURE ET D'IMPRESSION

(30) Priority: 09.08.2017 IT 201700092402
(43) Date of publication of application: 13.02.2019
(73) Proprietor: TAPEMATIC S.p.A., 20876 Ornago (Monza Brianza) (IT)
(72) Inventor: PEREGO, Luciano, 20876 ORNAGO (MONZA BRIANZA) (IT)
(74) Representative: Tansini, Elio Fabrizio

(56) References cited:
- EP-A1- 3 121 308
- WO-A1-2005/075170
- US-B1- 9 352 594

## Description

The present invention relates to an apparatus for articles surface finishing. The invention also relates to a finishing process actuatable by means of said apparatus.

At present, use of caps, lids, bottles, tubes or other containers having a high degree of surface finishing, exhibiting a metallescent, glossy or satin appearance is very much demanded, for example in the pharmaceutical field, in the cosmetics industry, and so on.

Such metallescent finishing is generally obtained via sputtering or other PVD technique (Phisical Vapor Deposition) which first provides for application of a primer layer on the surface of the article being processed, that is then subjected to a metallization process. For example, sputter metallization requires that the article be introduced into a high vacuum chamber, inside which a metal target hit by an electromagnetic radiation releases metal particles that deposit in the form of a thin layer (generally of a few nanometers) homogeneously distributed on the exposed surface of the article being processed.

Once the metallization process is terminated, the article is subjected to a lacquering treatment for the purpose of depositing a transparent, colourless layer or of a predetermined protective colour which, once dried, preserves the underlying metallization layer from mechanical abrasions, atmospheric agents and/or other external agents.

A surface finishing line of articles operating according to what is described above is, for example, disclosed in US 9,487,857, in the name of the same Applicant.

EP 2 121 208, in the name of the same Applicant, provides a process and an apparatus for decorating small objects in which the semi-finished product to be treated is subjected to a physical vapor deposition (PVD) or sputtering treatment, to provide a metallization layer on at least one of its surfaces. On the metallized surface, a three-dimensional impression is also formed, before or after metallization. By virtue of the three-dimensional impression, the metallization layer produced by the PVD treatment has a three-dimensional figure comprising a plurality of projections and/or recesses. The three-dimensional impression can be obtained by removing material, e.g by laser marking or other mechanical processing performed by a unit operating downstream of the metallization station, or by mechanical forming at a plastic deformation station placed upstream of the metallization station.

WO 2005/075170 proposes the application of graphic motifs on previously lacquered articles, in the absence of any superficial metallization process. US 9,352,594, in the name of the same applicant, relates to a finishing process of articles by digital printing, in the absence of any metallization treatment.

In many cases, particularly in the cosmetics industry but also in other sectors, it is further requested that further graphic patterns, such as identifying elements of a corporate brand, decorative or embellishment elements, and/or elements containing informative writings or the like, appear on the metallized finishing bottom, which occupies the entire surface extension of the article or a good part thereof.

Based on the current state of the art, application of such additional graphic patterns can be performed by means of printing techniques of different kinds, such as offset printing, digital printing, decal, pad printing, screen printing or the like.

In the processing of articles with a metallescent finishing, application of additional graphic elements currently provides that previously metallized articles undergo a further processing cycle being distinct and separate from the one used to generate the metallescent finishing.

In particular, it is in fact required that the articles exiting from the surface finishing line dedicated to metallization, be collected neatly in special containers and transferred to a different production site, often delocalized to tens or hundreds of kilometers, in order to undergo application of additional graphic patterns.

Once at the delocalized production site, the articles are subjected to further handling for the purpose of additional graphic patterns application and final packaging.

The diversified processing of the articles at different sites entails significant logistical complications, which negatively impact on production costs. Furthermore, repeated articles handling increases the possibility of damage and is often the cause of manufacturing defects with a consequent increase in waste and overall production costs.

The Applicant also observed that the graphic patterns applied to the articles are directly exposed to rubbing and mechanical stresses, as well as to the action of external atmospheric agents such as humidity and UV radiation that may jeopardize the prolonged maintenance of aesthetic characteristics. It was further observed that in many cases the transparent protective layer applied to protect the metallescent finishing, also for the purpose of meeting particular optical and/or tactile requirements, exhibits physical characteristics which are not compatible with a strong adhesion of the graphic patterns subsequently printed on the article. It follows that the graphic patterns may exhibit a low resistance to mechanical abrasion and wear, thereby compromising maintenance of the product aesthetic characteristics during use.

It is an object of the present invention to significantly simplify the production processes for obtaining articles with graphic patterns applied on a metallescent surface finishing.

A further object of the invention is to promote a permanent and lasting adhesion of the printed graphic patterns, thus offering the possibility of exploiting the protective coating applied at the end of the metallization process in order to obtain, where required, additional protection of the graphic patterns subsequently applied.

A further object of the present invention is also to provide an apparatus which lends itself to be easily adapted, as the case may be, for application of graphic patterns before and/or after application of the transparent protective layer.

It should be noted that, for the purposes of the present invention, by the term "printed" it is meant a graphic pattern produced by printing, i.e. by applying inks, pigments, or paints in liquid or powder form, directly on the surfaces of the article which is being processed or on a film subsequently applied to the article.

More specifically, according to a first aspect, the object of the present invention is an apparatus for articles surface finishing according to claim 1, comprising a transfer line carrying piece-holder members, each configured to retain an article being processed.

A metallization station operating along the transfer line is configured to deposit a surface metallization layer on each of the articles carried by the piece-holder members.

A lacquering station operating along the transfer line downstream of the metallization station is configured to deposit a transparent protective layer on the metallization layer of each article carried by the respective piece-holder member.

A marking station, i.e. a printing station, is operatively arranged downstream of the metallization station to provide at least one graphic pattern, preferably applied by printing, on each article carried by the respective piece-holder member.

According to a second aspect, the invention relates to a process for articles surface finishing according to claim 10, comprising the action of engaging a plurality of articles being processed on respective piece-holder members, each configured to retain one of said articles.

The articles held by the piece-holder members are moved along a transfer line.

In a metallization station operating along the transfer line, a surface metallization layer is deposited on each of the articles held by the piece-holder members.

In a lacquering station operating along the transfer line downstream of the metallization station, a transparent protective layer is deposited on the metallization layer of each article held by the respective piece-holder member.

In a station operating downstream of the metallization station, a graphic, preferably a printed pattern, is also provided on each article held by the respective piece-holder member.

In at least one of the above aspects, the invention may further comprise one or more of the following preferred features.

Preferably, said printing station is arranged upstream of the lacquering station, whereby the printed graphic pattern is applied beneath the transparent protective layer.

Preferably, an additional lacquering station is also provided, which operates downstream of the printing station in order to apply a final covering layer, thereby covering the graphic pattern applied on the transparent protective layer.

Preferably, said printing station is arranged downstream of the lacquering station, whereby the printed graphic pattern is applied on the transparent protective layer.

Preferably, each piece-holder member is rotatable, together with the respective article, around a predetermined geometric axis.

Preferably, orientation devices are also provided for arranging each article according to a predetermined orientation around the respective geometric axis, prior to application of the graphic pattern in the printing station.

Preferably, said orientation devices comprise at least one reading unit configured to locate an angular reference index carried by the article in proximity of the printing station, and to emit a positioning signal representative of an angular position presented by the angular reference index around the geometric axis.

Preferably, control devices are provided which operate on the piece-holder member in response to said positioning signal, for driving a rotation of the article around said geometric axis and stopping the rotation of the article when the angular reference index reaches a predetermined angular position around the geometric axis.

Preferably, a pre-treatment station operating upstream of the metallization station is provided for applying a surface base layer on each of the articles carried by the piece-holder members.

Preferably, said transfer line has a forward branch and a return branch placed parallel aside one to the other.

Preferably, said at least one marking station is installed in an auxiliary processing module operatively disposed astride both the forward and return branches of the transfer line.

Preferably, the auxiliary processing module is operatively arranged in an area interposed between the metallization station and the lacquering station.

Preferably, the auxiliary processing module exhibits a first and a second portion symmetrically arranged with respect to the transfer line.

Preferably, at least one of said first and second portions houses the marking station.

Preferably, the first portion extends from the forward branch of the transfer line, away from the return branch.

Preferably, the second portion extends from the return branch, away from the forward branch, specularly with respect to the first portion.

Preferably, the application of the graphic pattern is carried out before depositing said transparent protective layer, whereby the printed graphic pattern is applied beneath said protective layer.

Preferably, the application of the graphic pattern is carried out after deposition of the transparent protective layer, whereby the printed graphic pattern is applied on said protective layer.

Preferably, a final covering layer is also provided, to cover the graphic pattern printed on said transparent protective layer.

Preferably, each article is rotatably supported around a predetermined geometric axis.

Preferably, each article is arranged according to a predetermined orientation around the respective geometric axis, prior to application of the graphic pattern.

Preferably, arranging each article according to a predetermined orientation comprises the action of identifying an angular reference index carried by the article proximate the printing station.

Preferably, it is provided to emit a positioning signal representative of an angular position presented by the angular reference index around the geometric axis.

Preferably, in response to said positioning signal, it is provided to drive a rotation of the article around said geometric axis and to stop the rotation of the article when the angular reference index reaches a predetermined angular position around the geometric axis.

Preferably, in a pre-treatment station operating upstream of the metallization station, a surface base layer is applied to each of the articles carried by the piece-holder members.

Further characteristics and advantages will become more apparent from the detailed description of a preferred, yet not limiting, embodiment of an apparatus and a process for articles surface finishing, according to the present invention. Such description will be set forth hereinafter with reference to the accompanying drawings given only for illustrative and, therefore, non-limiting purpose, wherein:

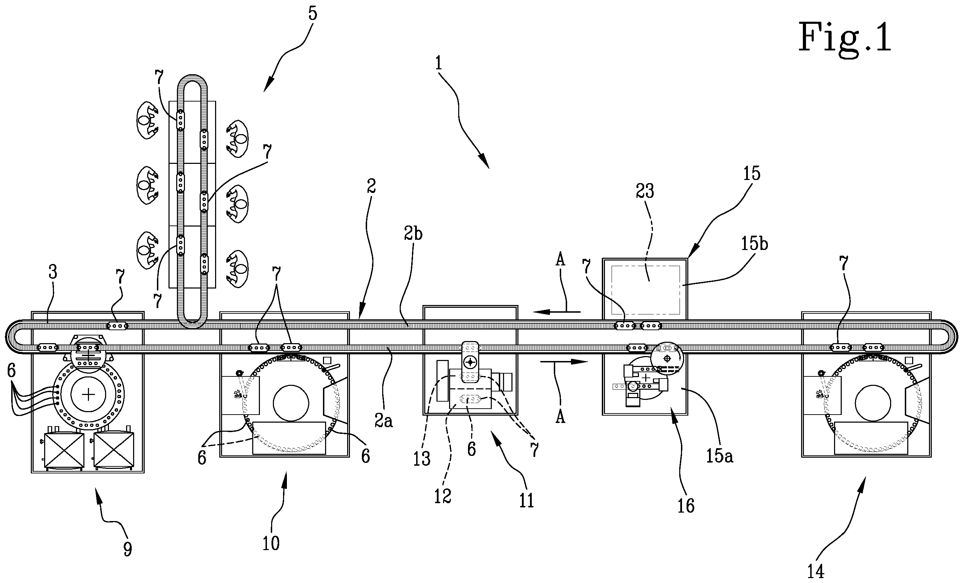

- Figure 1 is a prospective schematic view of an apparatus for articles surface finishing, according to the present invention;

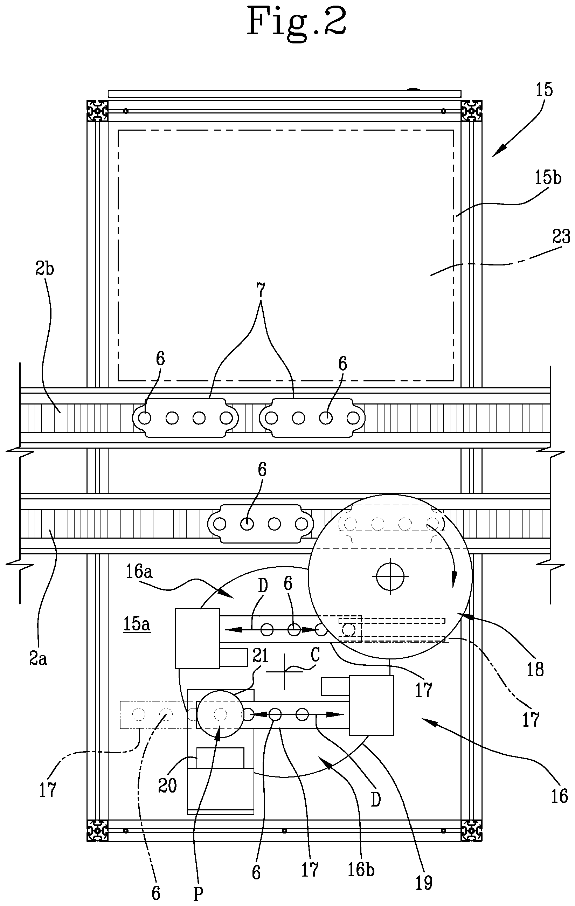

- Figure 2 shows an enlarged detail of Figure 1;
- Figure 3 shows schematically in cross-section an article being processed mounted on a respective piece-holder member carried by a tray;
- Figure 4 is a plan view of the tray of Figure 3, carrying a set of articles being processed.

With reference to the mentioned figures, by the numeral 1 it is indicated an apparatus for articles surface finishing in its entirety according to the present invention.

The apparatus 1 comprises a transfer line 2 along which, for example by means of one or more belt conveyors 3, a plurality of piece-holder members 4 are made to advance.

In the illustrated example, the transfer line 2 extends according to a closed line and exhibits a forward branch 2a and a return branch 2b parallel aside one to the other for at least a part of their development, and ending up at a loading-unloading station 5.

Each piece-holder member 4 is configured to removably engage and retain a respective article 6 being processed.

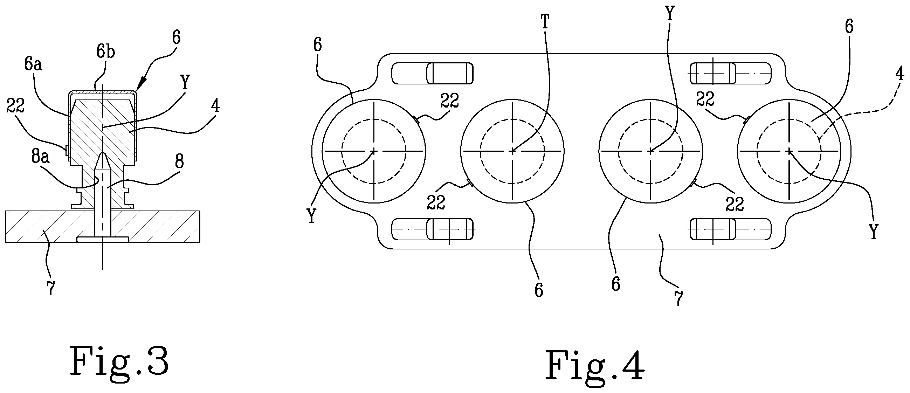

It may be provided that at least for the purpose of moving along the transfer line 2, the piece-holder members 4 are supported by respective trays 7, moved along the belt conveyor 3. Each tray 7 is suitable for engaging a predetermined number of piece-holder members 4. In the example of figures 3 and 4 four piece-holder members 4 are illustrated, albeit each tray can accommodate any number of piece-holder members, for example up to twelve.

Each piece-holder member 4 can be releasably engaged to the respective tray 7 by means of a support pin 8 which can be axially inserted along a respective cavity 8a, as for example disclosed in US 9,487,857.

The engagement of the articles 6 being processed on the respective piece-holder members 4, as well as the engagement of the latter on the trays 7, can be performed manually or automatically in the loading-unloading station 5 arranged along the transfer line 2. Once engagement has been obtained, each piece-holder member 4, and therefore the article 6 retained therefrom, is free to rotate about its own predetermined geometric axis Y, coinciding with the geometric axis of the support pin 8. The trays 7 positioned on the transfer line 2 at the loading-unloading station 5 advance along a feed direction A and, after passing through a possible conditioning station 9 in which they are cleaned and/or subjected to other preparation treatments, they reach a pre-treatment station 10 which applies a base surface layer (Base Coating) on each of the articles 6 carried by the piece-holder members 4.

The base layer can be obtained in the form of paint applied by spraying and subsequent drying, optionally with the aid of UV lamps and/or infrared radiation, as disclosed for example in US 9,487,857. In particular, it can be provided that for the purpose of applying the base layer each piece-holder member 4 is removed from the tray 7 and transferred onto support pins similar to those of the tray 7 itself, so that each article 6 may be driven in rotation through the respective piece-holder member 4 thus promoting a homogeneous distribution of the surface layer during application.

A metallization station 11 operates along the transfer line 2, downstream of the pre-treatment station 10. The metallization station 11 is configured to deposit a surface metallization layer on each of the articles 6 carried by the piece-holder members 4, preferably via a sputtering process or other PVD technique. For example, it may be provided that at the metallization station 11 each tray 7 is picked up by the belt conveyor 3 of the transfer line 2 and introduced, together with the piece-holder members 4 and the articles 6 carried therein, into a sputtering chamber 12 maintained in a high vacuum condition. Between the sputtering chamber 12 and the transfer line 2, at least one pre-chamber 13 can be interposed which may be alternatively switched between a load-discharge condition, at ambient pressure, in the presence of which the transfer of the tray 7 to or from the transfer line 2 is carried out, and a condition of forced vacuum transfer, in the presence of which the transfer of the tray 7 to or from the sputtering chamber 12 is carried out.

A lacquering station 14 operates along the transfer line 2 downstream of the metallization station 11. The lacquering station 14 is configured to deposit a transparent protective layer (Top Coating) on the metallization layer of each article 6 carried by the respective piece-holder member 4. The transparent protective layer can be colourless or, if desired, pigmented according to a desired chromatic tint.

Similarly to what has been described with reference to the pre-treatment station 10, the protective layer applied in the lacquering station 14 can be obtained in the form of paint applied by spraying and subsequent drying, optionally with the aid of UV lamps and/or infrared radiation. In particular, it can be provided that for the purpose of applying the protective layer each piece-holder member 4 is removed from the tray 7 and transferred on support pins similar to those of the tray 7, so that each article 6 can be driven in rotation through the respective piece-holder member 4, to promote a homogeneous distribution of the protective layer during application.

In the illustrated example there is further provided an auxiliary processing module 15 operatively disposed astride both the forward 2a and return branches 2b of the transfer line 2, in an area interposed between the metallization station 11 and the lacquering station 14. Preferably, the auxiliary processing module 15 has a first and a second portion 15a, 15b symmetrically arranged with respect to the transfer line 2. The first portion 15a extends from the forward branch 2a of the transfer line 2, preferably perpendicular thereto, away from the return branch 2b. The second portion 15b extends from the return branch 2b, away from the forward branch 2a, specularly with respect to the first portion 15a.

The apparatus 1 further comprises at least one printing station 16 operatively arranged downstream of the metallization station 11 to apply at least one graphic pattern printed on each article 6.

Preferably, the printing station 16 is housed in the auxiliary processing module 15, in at least one of the first and second portions 15a, 15b thereof.

In a preferential embodiment, the printing station 16 is installed in the first portion 15a of the auxiliary processing module 15. In this case, the printing station 16 operates between the metallization station 11 and the lacquering station 14, upstream of the latter, preferably along the forward branch 2a of the transfer line 2. The graphic pattern applied by the printing station 16 is in this case interposed between the metallization layer and the transparent protective layer. The graphic pattern is therefore protected from wear phenomena, abrasions and mechanical damages, as well as from the effects of atmospheric agents such as oxidation, humidity or chemical substances with which article 6 can come into contact. The second portion 15b of the auxiliary module 15 can in this case be used for the installation of any additional equipment operating along the return branch 2b of the transfer line 2. For example, a qualitative control station 23 of the treated articles 6 may be provided.

In a second preferred embodiment, not shown, the printing station 16 is installed in the second portion 15b of the auxiliary processing module 15. In this case, the printing station 16 operates downstream of the lacquering station 14, and the graphic pattern is suitable for being applied on the protective layer. Therefore, a transparent pigmented protective layer may be obtained, without the colour of the protective layer influencing the external appearance of the printed graphic pattern.

An additional lacquering station (not shown) may be optionally installed downstream of the printing station 16 operating downstream of the lacquering station 14, to apply a transparent, preferably colourless, final covering layer to cover the printed graphic pattern over the protective layer obtained by the lacquering station 14. The articles coming from the return branch 2b of the transfer line 2 can be diverted to the pre-treatment station 10 to undergo application of the final covering layer before reaching the loading-unloading station 5. In fact, the additional lacquering station may, for example, be represented by the pre-treatment station 10.

According to a third preferred embodiment, not shown, there are provided a first and a second printing station 16 arranged respectively in the first and second portion 15a, 15b of the auxiliary processing module 15. In this case, the first and second printing stations 16 respectively give shape to a first and second graphic pattern, respectively arranged inside and outside the transparent protective layer. Also in this case an additional lacquering station installed downstream of the second printing station may be provided for applying a transparent, preferably colourless, final covering layer thus covering the second printed graphic pattern.

Similarly to what has been described with reference to the pre-treatment station 10 and to the lacquering station 14, it is preferably provided that for the purpose of applying the graphic pattern the piece-holder members 4 be removed from the respective tray 7 and transferred onto supporting elements similar to the support pins 8 carried by the tray 7 itself. For this purpose, the printing station 16 can for example comprise at least one loader 17 fed by a manipulator 18. In the illustrated example, there are provided two loaders 17 specularly arranged with respect to the centre of rotation C of a rotatable structure 19. The rotatable structure 19 can be actuated with rotations by 180° about its centre of rotation C, to reciprocally exchange the positions of the trays 7 between a loading area 16a, which can be reached by the manipulator 18, and a working area 16b.

At each work cycle, the manipulator 18 interacts with one of the trays 7 along the transfer line 2, with the piece-holder members 4 being withdrawn in order to remove the articles 6 and release them onto the loader 17 which occupies the loading area 16a. Preferably, for the purposes of the transfer, the manipulator 18 engages the piece-holder members 4, without coming into contact with the articles 6. It is thus possible to prevent possible damage to the metallization layer and/or the protective layer.

With a 180° rotation of the rotatable structure 19, the loader 17 which received the articles 6 together with the respective piece-holder members 4 is transferred to the working area 16b. Simultaneously, the loader 17 coming from the working area 16b is brought back into the loading area 16a to allow the manipulator 18 to again transfer the processed articles 6 onto the tray 7 waiting on the transfer line 2. The articles 6 carried by the loader 17 in the working area 16b are made to advance together with the respective piece-holder members 4 along their mutual alignment direction D, preferably according to a step-by-step movement, in order to be sequentially brought into a printing position P. At least one printing unit 20 operates at the printing position P with the former being configured to realize the graphic pattern on the article 6. Depending on the requirements, the printing unit 20 can be configured to realize the printed graphic pattern in various ways, for example according to a technique chosen between offset printing, digital printing, decal, pad printing, screen printing or other.

In the illustrated example, the printing unit 20 is suitable for operating on a side surface 6a of the article 6 being processed, substantially parallel to the geometric axis Y. It may be provided that during printing the article 6 be rotated through the respective piece-holder member 4 around the geometric axis Y, in order that correct application of the graphic pattern is promoted.

In addition or alternatively, a printing unit 20 may be provided which is configured to operate on a base surface 6b of article 6, substantially perpendicular to the rotation axis. In this case, the article 6 being processed is preferably kept stationary during printing.

The apparatus 1 can further comprise orientation devices 21 configured to arrange each article 6 according to a predetermined orientation around the respective geometric axis Y, prior to application of the graphic pattern in the printing station 16.

In this regard, it is provided that at least one angular reference index 22 is associated with each of the articles 6 being processed, preferably located around its own geometric axis Y. This angular reference index 22 may for example be constituted by an insert, a recess or a notch printed or embossed on a side surface 6a of the article 6, or on the piece-holder member 4. The angular reference index 22 can possibly be defined by a first graphic pattern, printed for example on the base surface 6b of the article 6, so that a second graphic pattern printed on the side surface 6a is correctly positioned and/or oriented with respect to the first graphic pattern, or vice versa.

The orientation devices preferably comprise at least one reading unit 21 configured to identify the angular reference index 22 carried by the article 6 in proximity of the printing station 16. In the illustrated example, the reading unit 21 operates in the printing position P, although a different location thereof is not excluded, for example along the transfer line 2

The reading unit 21, for example of the optical (camera) mechanical (probe) or inductive (proximity magnetic sensor) type, is suitable to emit a positioning signal representative of a position presented by the angular reference index 22 around the geometric axis Y. For example, the positioning signal may be emitted when the angular reference index 22 reaches a predetermined angular position around the geometric axis Y of the article 6 being processed, while the latter is made to rotate through the piece-holder member 4 by a motor or other suitable control devices (not shown). In response to the positioning signal, the control devices stop the rotation of the article 6 when the angular reference index 22 reaches the predetermined angular position around the geometric axis Y.

It is therefore possible to promote the realization of one or more graphic patterns in one or more predefined positions around article 6.

## Claims

1. Apparatus for surface finishing of articles, comprising:
a transfer line (2) carrying piece-holder members (4), each configured to retain an article (6) which is being worked;
a metallization station (11) operating along the transfer line (2) and configured to deposit a surface metallization layer on each of the articles (6) carried by the piece-holder members (4);
a lacquering station (14) operating along the transfer line (2) downstream of the metallization station (11) and configured to deposit a transparent protective layer on the metallization layer of each article (6) carried by the respective piece-holder member (4);
**characterized in that** it further comprises at least one printing station (16) operatively disposed downstream of the metallization station (11) for applying at least one printed graphic pattern on each article (6) carried by the respective piece-holder member (4).

2. Apparatus according to claim 1, wherein said printing station (16) is located upstream of the lacquering station (14), whereby the printed graphic pattern is applied beneath the transparent protective layer.

3. Apparatus according to claim 1, wherein said printing station (16) is located downstream of the lacquering station (14), whereby the printed graphic pattern is applied over the transparent protective layer.

4. Apparatus according to claim 3, further comprising an additional lacquering station operating downstream of the printing station (16) for applying a final covering layer to cover the graphic pattern applied over the transparent protective layer.

5. Apparatus according to one or more of the preceding claims, wherein each piece-holder member (4) is rotatable jointly with the respective article (6) around a predetermined geometric axis (Y).

6. Apparatus according to one or more of the preceding claims, further comprising orienting devices (21) configured to arrange each article (6) according to a predetermined orientation around the respective geometric axis (Y) prior to applying the graphic pattern at the printing station (16).

7. Apparatus according to claim 6, wherein said orienting devices comprise:
at least one reading unit (21) configured to locate an angular reference index (22) carried by the article (6) near the printing station (16), and emit a positioning signal representative of an angular position presented by the angular reference index (22) around the geometric axis (Y);
control devices operating on the piece-holder member (4) in response to said positioning signal, for driving a rotation of the article (6) around said geometric axis (Y) and stopping the rotation of the article (6) when the angular reference index (22) reaches a predetermined angular position around the geometric axis (Y).

8. Apparatus according to one or more of the preceding claims, wherein said transfer line (2) has a forward branch (2a) and a return branch (2b) placed parallel aside one to the other, said at least one printing station (16) being installed in an auxiliary treatment module (15) operatively disposed astride both the forward and return branches (2a, 2b) of the transfer line (2).

9. Apparatus according to claim 8, wherein the auxiliary treatment module (15) has a first and a second portion (15a,15b) symmetrically arranged with respect to the transfer line (2), said printing station (16) being housed in one of said first and second portion (15a, 15b).

10. Procedure for articles surface finishing, comprising:
engaging a plurality of articles (6) being worked on respective piece-holder members (4), each configured to retain one of said articles (6);
moving along a transfer line (2) the articles (6) held by the piece-holder members (2);
in a metallization station (11) operating along the transfer line (2), depositing a surface metallization layer on each of the articles (6) retained by the piece-holder members (4);
in a lacquering station (14) operating along the transfer line (2) downstream of the metallization station (11), depositing a transparent protective layer on the metallization layer of each article (6) held by the respective piece-holder member (4);
**characterized in that** a printed graphic pattern is applied to each article (6) held by the respective part-piece member (4), at a printing station (16) operating downstream of the metallization station (11).

11. A process according to claim 10, wherein application of the graphic pattern is achieved before depositing said transparent protective layer, whereby the printed graphic pattern is applied beneath said protective layer.

12. A process according to claim 10 or 11, wherein the application of the graphic pattern is achieved after deposition of the transparent protective layer, whereby the printed graphic pattern is applied over said transparent protective layer.

13. A process according to claim 12, further comprising the application of an ultimate covering layer, to cover the graphic pattern printed over said transparent protective layer.

14. A process according to one or more of claims 10 to 13, wherein each article (6) is rotatably supported around a predetermined geometric axis (Y) and is arranged according to a predetermined orientation around the respective geometric axis (Y) prior to application of the graphic pattern.

15. A process according to claim 14, wherein arranging each article (6) according to a predetermined orientation comprises the actions of:
locating an angular reference index (22) carried by the article (6) near the printing station (16);
emitting a positioning signal representative of an angular position presented by the angular reference index (22) around the geometric axis (Y);
in response to said positioning signal, driving rotation of the article (6) around said geometric axis (Y) and stopping rotation of the article (6) when the angular reference index (22) reaches a predetermined angular position around the geometric axis (Y).

## Patentansprüche

1. Einrichtung für die Oberflächenbearbeitung von Artikeln, umfassend:
eine Transferanlage (2), die Stückhalterelemente (4) trägt, von denen ein jedes ausgelegt ist, um einen Artikel (6) zu halten, der bearbeitet wird;
eine Metallisierungsstation (11), die entlang der Transferanlage (2) arbeitet und ausgelegt ist, um eine Oberflächenmetallisierungsschicht auf einem jeden der Artikel (6), getragen von den Stückhalterelementen (4), abzulegen;
eine Lackierstation (14), die entlang der Transferanlage (2) nach der Metallisierungsstation (11) arbeitet und ausgelegt ist, um eine durchsichtige Schutzschicht auf der Metallisierungsschicht eines jeden Artikels (6), getragen vom jeweiligen Stückhalterelement (4), abzulegen,
**dadurch gekennzeichnet, dass** sie zudem mindestens eine Druckstation (16) umfasst, die betriebswirksam nach der Metallisierungsstation (11) angeordnet ist, um mindestens ein gedrucktes grafisches Muster an einem jeden Artikel (6), getragen vom jeweiligen Stückhalterelement (4), anzubringen.

2. Einrichtung nach Anspruch 1, wobei die Druckstation (16) vor der Lackierstation (14) angeordnet ist, wodurch das gedruckte grafische Muster unter der durchsichtigen Schutzschicht angebracht wird.

3. Einrichtung nach Anspruch 1, wobei die Druckstation (16) nach der Lackierstation (14) angeordnet ist, wodurch das gedruckte grafische Muster über der durchsichtigen Schutzschicht angebracht wird.

4. Einrichtung nach Anspruch 3, zudem umfassend eine zusätzliche Lackierstation, die nach der Druckstation (16) arbeitet, um eine abschließende Abdeckschicht anzubringen, um das grafische Muster, das über der durchsichtigen Schutzschicht angebracht wurde, zu überziehen.

5. Einrichtung nach einem oder mehreren der vorhergehenden Ansprüche, wobei ein jedes Stückhalterelement (4) gemeinsam mit dem jeweiligen Artikel (6) rund um eine vorgegebene geometrische Achse (Y) drehbar ist.

6. Einrichtung nach einem oder mehreren der vorhergehenden Ansprüche, zudem umfassend Ausrichtungsvorrichtungen (21), die ausgelegt sind, um einen jeden Artikel (6) nach einer vorgegebenen Ausrichtung rund um die jeweilige geometrische Achse (Y) auszurichten, bevor das grafische Muster an der Druckstation (16) angebracht wird.

7. Einrichtung nach Anspruch 6, wobei die Ausrichtungsvorrichtungen umfassen:
mindestens eine Abtasteinheit (21), die ausgelegt ist, um einen Winkelreferenzindex (22) zu lokalisieren, getragen vom Artikel (6) in der Nähe der Druckstation (16), und um ein Positionierungssignal auszusenden, das repräsentativ für eine Winkelposition ist, die vom Winkelreferenzindex (22) rund um die geometrische Achse (Y) dargestellt ist;
Steuervorrichtungen, die auf das Stückhalterelement (4) als Reaktion auf das Positionierungssignal wirken, um eine Drehung des Artikels (6) rund um die geometrische Achse (Y) zu veranlassen und um die Drehung des Artikels (6) zu stoppen, wenn der Winkelreferenzindex (22) eine vorgegebene Winkelposition rund um die geometrische Achse (Y) erreicht.

8. Einrichtung nach einem oder mehreren der vorhergehenden Ansprüche, wobei die Transferanlage (2) einen Vorwärtsabzweig (2a) und einen Rückwärtsabzweig (2b) aufweist, die parallel nebeneinander angeordnet sind, wobei mindestens eine Druckstation (16) in einem Hilfsbearbeitungsmodul (15) installiert ist, betriebswirksam gleichauf angeordnet sowohl mit dem Vorwärts- als auch dem Rückwärtsabzweig (2a, 2b) der Transferanlage (2).

9. Einrichtung nach Anspruch 8, wobei das Hilfsbearbeitungsmodul (15) einen ersten und einen zweiten Abschnitt (15a, 15b) aufweist, die symmetrisch zur Transferanlage (2) angeordnet sind, wobei die Druckstation (16) entweder im ersten oder im zweiten Abschnitt (15a, 15b) untergebracht ist.

10. Verfahren für die Oberflächenbearbeitung von Artikeln, umfassend:
das Eingreifen einer Vielzahl an Artikeln (6), die auf jeweiligen Stückhalterelementen (4) bearbeitet werden, ein jeder ausgelegt, um einen der Artikel (6) zu halten;
das Bewegen der von den Stückhalterelementen (2) gehaltenen Artikel (6) entlang der Transferanlage (2);
in einer Metallisierungsstation (11), die entlang der Transferanlage (2) arbeitet, das Ablegen einer Oberflächenmetallisierungsschicht auf einem jeden der Artikel (6), die von den Stückhalterelementen (4) gehalten werden;
in einer Lackierstation (14), die entlang der Transferanlage (2) nach der Metallisierungsstation (11) arbeitet, das Ablegen einer durchsichtigen Schutzschicht auf der Metallisierungsschicht eines jeden vom jeweiligen Stückhalterelement (4) gehaltenen Artikels (6),
**dadurch gekennzeichnet, dass** an jedem vom jeweiligen Stückhalterelement (4) gehaltenen Artikel (6) an einer Druckstation (16), die nach der Metallisierungsstation (11) arbeitet, ein gedrucktes grafisches Muster angebracht wird.

11. Verfahren nach Anspruch 10, wobei das Anbringen des grafischen Musters vor dem Ablegen der durchsichtigen Schutzschicht erfolgt, wodurch das gedruckte grafische Muster unter der Schutzschicht angebracht wird.

12. Verfahren nach Anspruch 10 oder 11, wobei das Anbringen des grafischen Musters nach dem Ablegen der durchsichtigen Schutzschicht erfolgt, wodurch das gedruckte grafische Muster über der Schutzschicht angebracht wird.

13. Verfahren nach Anspruch 12, zudem umfassend das Anbringen einer abschließenden Abdeckschicht, um das über der durchsichtigen Schutzschicht gedruckte grafische Muster zu überziehen.

14. Verfahren nach einem oder mehreren der Ansprüche 10 bis 13, wobei ein jeder Artikel (6) drehbar rund um eine vorgegebene geometrische Achse (Y) getragen wird und nach einer vorgegebenen Ausrichtung rund um die jeweilige geometrische Achse (Y) vor dem Anbringen des grafischen Musters angeordnet ist.

15. Verfahren nach Anspruch 14, wobei das Anordnen eines jeden Artikels (6) nach einer vorgegebenen Ausrichtung, die Vorgänge umfasst:
Lokalisieren eines Winkelreferenzindex (22), getragen vom Artikel (6) in der Nähe der Druckstation (16);
Aussenden eines Positionierungssignals, das repräsentativ für eine Winkelposition ist, die vom Winkelreferenzindex (22) rund um die geometrische Achse (Y) dargestellt ist;
als Reaktion auf das Positionierungssignal Veranlassen der Drehung des Artikels (6) rund um die geometrische Achse (Y) und Stoppen der Drehung des Artikels (6), wenn der Winkelreferenzindex (22) eine vorgegebene Winkelposition rund um die geometrische Achse (Y) erreicht.

## Revendications

1. Appareil pour la finition de surface d'articles, comprenant :
une ligne de transfert (2) transportant des organes (4) de support de pièces, chacun étant configuré pour retenir un article (6) en train d'être travaillé ;
un poste de métallisation (11) fonctionnant le long de la ligne de transfert (2) et configuré pour déposer une couche de métallisation de surface sur chacun des articles (6) transportés par les organes (4) de support de pièces ;
un poste de laquage (14) fonctionnant le long de la ligne de transfert (2) en aval du poste de métallisation (11) et configuré pour déposer une couche de protection transparente sur la couche de métallisation de chaque article (6) transporté par l'organe (4) de support de pièces respectif ;
**caractérisé en ce qu'**il comprend de plus au moins un poste d'impression (16) disposé de manière opérationnelle en aval du poste de métallisation (11) pour appliquer au moins un motif graphique imprimé sur chaque article (6) transporté par l'organe (4) de support de pièces respectif.

2. Appareil selon la revendication 1, dans lequel ledit poste d'impression (16) est situé en amont du poste de laquage (14), par lequel le motif graphique imprimé est appliqué sous la couche de protection transparente.

3. Appareil selon la revendication 1, dans lequel ledit poste d'impression (16) est situé en aval du poste de laquage (14), par lequel le motif graphique imprimé est appliqué sur la couche de protection transparente.

4. Appareil selon la revendication 3, comprenant de plus un poste de laquage supplémentaire fonctionnant en aval du poste d'impression (16) pour appliquer une couche de couverture finale afin de recouvrir le motif graphique appliqué sur la couche de protection transparente.

5. Appareil selon l'une ou plusieurs des revendications précédentes, dans lequel chaque organe (4) de support de pièces peut tourner conjointement avec l'article (6) respectif autour d'un axe géométrique (Y) prédéterminé.

6. Appareil selon l'une ou plusieurs des revendications précédentes, comprenant de plus des dispositifs d'orientation (21) configurés pour disposer chaque article (6) selon une orientation prédéterminée autour de l'axe géométrique (Y) respectif avant d'appliquer le motif graphique au poste d'impression (16).

7. Appareil selon la revendication 6, dans lequel lesdits dispositifs d'orientation comprennent :
au moins une unité de lecture (21) configurée pour localiser un indice de référence (22) angulaire porté par l'article (6) à proximité du poste d'impression (16), et pour émettre un signal de positionnement représentatif d'une position angulaire présentée par l'indice de référence (22) angulaire autour de l'axe géométrique (Y) ;
des dispositifs de commande agissant sur l'organe (4) de support de pièces en réponse au dit signal de positionnement, pour entraîner une rotation de l'article (6) autour dudit axe géométrique (Y) et arrêter la rotation de l'article (6) lorsque l'indice de référence (22) angulaire atteint une position angulaire prédéterminée autour de l'axe géométrique (Y) .

8. Appareil selon l'une ou plusieurs des revendications précédentes, dans lequel ladite ligne de transfert (2) comporte une branche vers l'avant (2a) et une branche de retour (2b) placées parallèlement l'une à côté de l'autre, ledit au moins un poste d'impression (16) étant installé dans un module de traitement (15) auxiliaire disposé fonctionnellement à cheval sur les deux branches vers l'avant et de retour (2a, 2b) de la ligne de transfert (2).

9. Appareil selon la revendication 8, dans lequel le module de traitement (15) auxiliaire comporte une première et une seconde partie (15a, 15b) disposées symétriquement par rapport à la ligne de transfert (2), ledit poste d'impression (16) étant logé dans l'une desdites première et seconde parties (15a, 15b).

10. Procédé de finition de surface d'articles, comprenant :
mettre en prise une pluralité d'articles (6) en train d'être travaillés sur des organes (4) de support de pièces respectifs, chacun étant configuré pour retenir l'un desdits articles (6) ;
déplacer le long d'une ligne de transfert (2) les articles (6) maintenus par les organes (2) de support de pièces ;
dans un poste de métallisation (11) fonctionnant le long de la ligne de transfert (2), déposer une couche de métallisation de surface sur chacun des articles (6) retenus par les organes (4) de support de pièces ;
dans un poste de laquage (14) fonctionnant le long de la ligne de transfert (2) en aval du poste de métallisation (11), déposer une couche de protection transparente sur la couche de métallisation de chaque article (6) maintenu par l'organe (4) de support de pièces respectif ;
**caractérisé en ce qu'**un motif graphique imprimé est appliqué sur chaque article (6) maintenu par l'organe (4) de support de pièces respectif, à un poste d'impression (16) fonctionnant en aval du poste de métallisation (11).

11. Procédé selon la revendication 10, dans lequel l'application du motif graphique est réalisée avant le dépôt de ladite couche protectrice transparente, par lequel le motif graphique imprimé est appliqué sous ladite couche protectrice.

12. Procédé selon la revendication 10 ou 11, dans lequel l'application du motif graphique est réalisée après le dépôt de ladite couche protectrice transparente, par lequel le motif graphique imprimé est appliqué sur ladite couche protectrice transparente.

13. Procédé selon la revendication 12, comprenant de plus l'application d'une couche de couverture finale, pour recouvrir le motif graphique imprimé sur ladite couche protectrice transparente.

14. Procédé selon l'une ou plusieurs des revendications de 10 à 13, dans lequel chaque article (6) est supporté de façon rotative autour d'un axe géométrique (Y) prédéterminé et est disposé selon une orientation prédéterminée autour de l'axe géométrique (Y) respectif avant l'application du motif graphique.

15. Procédé selon la revendication 14, dans lequel la disposition de chaque article (6) selon une orientation prédéterminée comprend les actions de :
localiser un indice de référence (22) angulaire porté par l'article (6) à proximité du poste d'impression (16) ;
émettre un signal de positionnement représentatif d'une position angulaire présentée par l'indice de référence (22) angulaire autour de l'axe géométrique (Y) ;
en réponse au dit signal de positionnement, entraîner la rotation de l'article (6) autour dudit axe géométrique (Y) et arrêter la rotation de l'article (6) lorsque l'indice de référence (22) angulaire atteint une position angulaire prédéterminée autour de l'axe géométrique (Y).
